Europäisches Patentamt

European Patent Office

Office européen des brevets

(11) Publication number: **0 563 991 A2**

## EUROPEAN PATENT APPLICATION

(21) Application number: **93105517.2**

(22) Date of filing: **02.04.93**

(51) Int. Cl.⁵: **H01L 33/00**

(30) Priority: **03.04.92 JP 82397/92**

(43) Date of publication of application:
**06.10.93 Bulletin 93/40**

(84) Designated Contracting States:
**DE FR GB**

(71) Applicant: **EASTMAN KODAK COMPANY**
**343 State Street**
**Rochester, New York 14650-2201(US)**

(72) Inventor: **Tanaka, Yukio, c/o Eastman Kodak**
**Company**
**Patent Legal Staff,**
**343 State Street**
**Rochester, New York 14650-2201(US)**
Inventor: **Toyama, Toshihiko, c/o Eastman**
**Kodak Company**
**Patent Legal Staff,**
**343 State Street**
**Rochester, New York 14650-2201(US)**

(74) Representative: **Wagner, Karl H. et al**
**WAGNER & GEYER**
**European Patent Attorneys**
**Gewürzmühlstrasse 5**
**D-80538 München (DE)**

(54) **Light-emitting apparatus.**

(57) A light-emitting device in which the intensity of the external light emission can be maintained at a substantially constant level even when the temperature of the light-emitting section rises. The device is provided with an optical filter means consisting of multiple layers of thin films of different refractive indexes that enables the decrease in emission intensity caused by a rise in the temperature of the light-emitting section to be compensated for by an increase in transmittivity.

FIG. 1

## BACKGROUND OF THE INVENTION

### Field of the Invention

The present invention relates to a light-emitting device, and more particularly to a light-emitting device that uses a light-emitting diode.

### Description of the Prior Art

P-n junction light-emitting diodes are used in optical printers that use a beam of light to record information, in image and bar-code reading systems that utilize the intensity of reflected light, and in optical communications devices that utilize optical signals.

These light-emitting diodes include a junction of p- and n-type semiconductor material which form a light-emitting section that emits light of a prescribed wavelength by the application of a forwardly-biased voltage across the p-n junction. Usually a thin film of silicon nitride or the like is formed at the light-emitting section, which serves to protect the light-emitting section while also allowing the external emission of the light produced by the light-emitting section.

The energy efficiency of light-emitting diodes is low, no more than several percent, with most of the injected electrical energy being converted into heat in the light-emitting section. This produces a rapid rise in the temperature of the light-emitting section which is accompanied by a reduction in the energy gap of the junction, thereby reducing the light emission intensity and lengthening the wavelength of the emitted light.

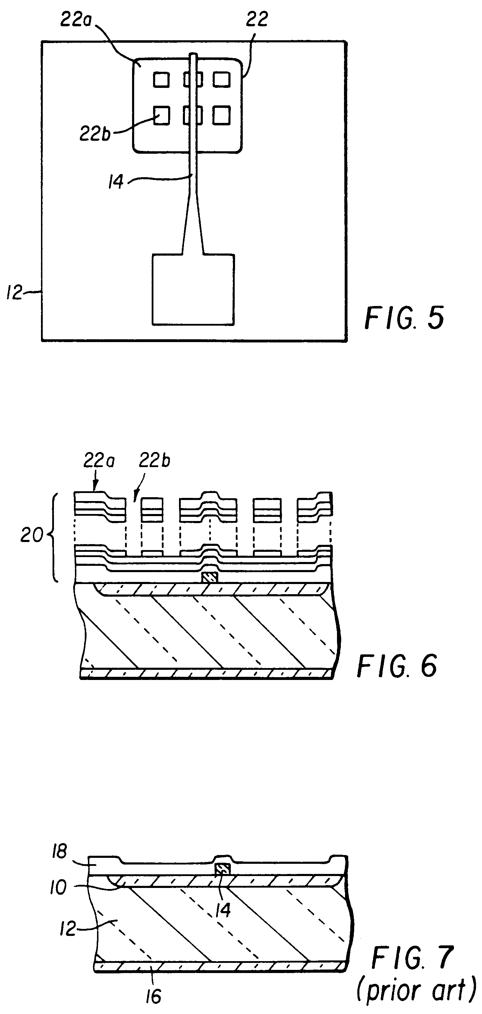

Figure 7 shows the structure of a conventional light-emitting device that uses a p-n junction light-emitting diode. With reference to the drawing, zinc is diffused into GaAsP semiconductor to form a p-type GaAsP semiconductor layer 10, and tellurium is diffused into GaAsP semiconductor to form an n-type GaAsP semiconductor layer 12. The upper surface of the p-type GaAsP semiconductor layer 10 is then provided with a positive electrode 14 and the lower surface of the n-type GaAsP semiconductor 12 is provided with a negative electrode 16. Also formed on the upper surface of the p-type GaAsP semiconductor layer 10 is a silicon nitride thin film layer 18 that serves as a protective layer while also allowing the transmission of the emitted light. Applying a forwardly biased voltage to the p-n junction via the positive electrode 14 and negative electrode 16 produces an emission of light having a center wavelength of 685 nm.

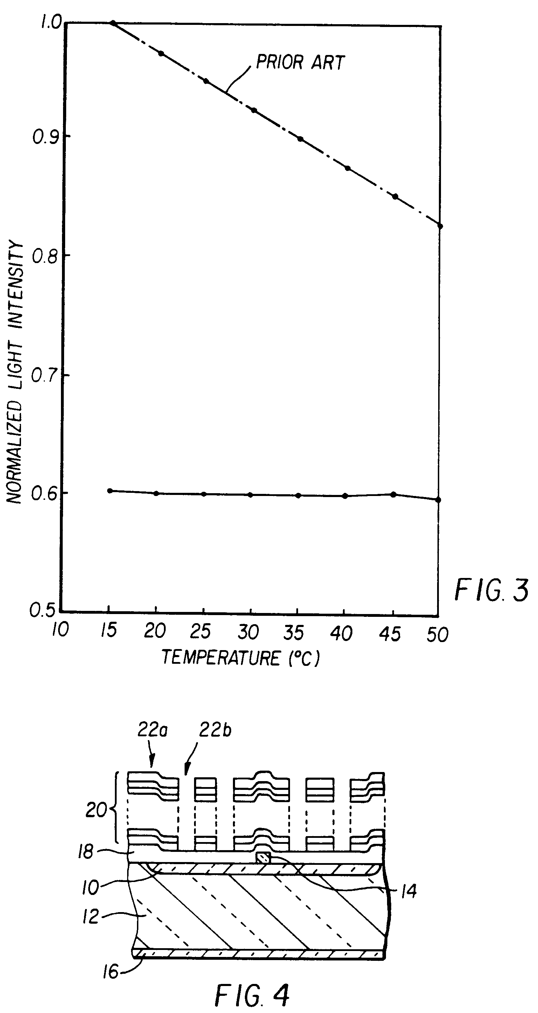

The broken line in the graph of Figure 3 represents emission intensity plotted against temperature in the case of the type of conventional light-emitting device described above. The horizontal axis is temperature in degrees centigrade, and the vertical axis is normalized light intensity. It can be seen that a rise in the temperature of the light-emitting section from room temperature (15°C) is accompanied by a gradual decrease in light intensity from 1.0. With this rise in temperature, the center wavelength shifts toward the longer wavelength side of the spectrum at a rate of about 0.24 nm/°C.

Thus, the problem with conventional light-emitting devices has been that the intensity of the emitted light decreases as the temperature of the emission section rises. When such a light-emitting device is used as the light source in an optical printer, image reader or other such optical communication apparatus, this decrease in light intensity degrades the image ouality, increases the read-error rate and produces a deterioration of the signal-to-noise ratio.

## SUMMARY OF THE INVENTION

In view of the above drawbacks of the conventional arrangement, an object of the present invention is to provide a light-emitting device in which the intensity of the externally emitted light is maintained at a substantially constant level even when the temperature of the light-emitting section rises.

In accordance with the present invention, this object is achieved by a light-emitting device, comprising:

a) a light-emitting section providing a p-n junction which emits light; and

b) optical filter means having a plurality of thin film layers disposed relative to the light-emitting section for providing increased light transmittivity in response to a decrease in emitted light caused by a rise in temperature of the light-emitting section.

The object is also achieved by the above-described light-emitting device in which the optical filter means includes a multiple-layer arrangement formed by alternating thin film layers that have different indexes of refraction.

The object is also achieved in the light-emitting device thus constituted in which the optical filter means includes is formed over a portion having a prescribed area ratio relative to the area of the light-emitting section for transmitting a portion of the light emitted by the light-emitting section.

The object is further achieved in the light-emitting device thus constituted in which the optical filter means includes multiple optical filters having different transmission characteristics at different positions on the device.

As described above, the intensity of the emitted light decreases with the rise in temperature of the emission section, and there is a shift to the longer wavelength side of the spectrum. If this shift to the longer wavelength is utilized and the wavelength is made to depend on the transmission characteristics of the thin film so that the shift to the longer wavelength is accompanied by an increase in transmittivity, it becomes possible to compensate for the decrease in light intensity.

Further features of the invention, its nature and various advantages will become more apparent from the accompanying drawings and following detailed description of the invention.

BRIEF DESCRIPTION OF THE DRAWINGS

Figure 1 is a cross-sectional view showing the arrangement of a light-emitting device according to a first embodiment of the present invention;
Figure 2 is a graph showing the emission spectrum and the optical filter transmittivity of the device of the first embodiment;
Figure 3 is a graph showing the temperature dependency of the light emission intensity of the device of this invention and of a conventional device;
Figure 4 is a cross-sectional view showing the arrangement of a light-emitting device according to a second embodiment of the present invention;
Figure 5 is a plan view of the light-emitting device of the second embodiment;
Figure 6 is a cross-sectional view showing the arrangement of a light-emitting device according to a third embodiment of the present invention; and
Figure 7 is a cross-sectional view showing the arrangement of a conventional light-emitting device.

DESCRIPTION OF THE PREFERRED EMBODIMENTS

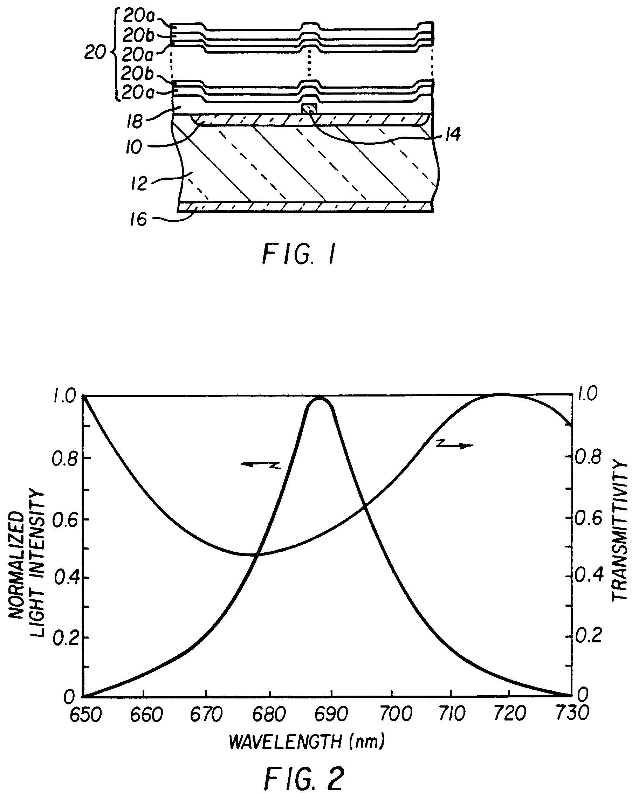

Figure 1 shows the structure of a light-emitting device according to a first embodiment of this invention. With reference to the drawing, zinc is diffused into GaAsP semiconductor to form a p-type GaAsP semiconductor layer 10 and tellurium is diffused into GaAsP semiconductor to form an n-type GaAsP semiconductor layer 12. The upper surface of the p-type GaAsP semiconductor layer 10 is then provided with a positive electrode 14 and the lower surface of the n-type GaAsP semiconductor 12 is provided with a negative electrode 16. A mixed crystal ratio of $GaAs_{0.32}P_{0.68}$ is used. A silicon nitride thin film 18 with a thickness of 275 nm and a refractive index of 1.87 is then formed on the upper surface of the p-type GaAsP semiconductor layer 10.

This invention is characterized by the further formation, on the silicon nitride thin film 18, of an optical filter comprised of alternating layers of two types of thin film having different refractive indexes. Specifically, an optical filter 20 is constituted of alternating layers of a titanium oxide thin film 20a that is 60 nm thick and has a refractive index of 2.35, and a silicon oxide thin film 20b that is 104 nm thick and has a refractive index of 1.35. In the case of this first embodiment, the optical filter 20 consists of a total of 20 such layers.

When a forwardly biased voltage is applied across the positive electrode 14 and negative electrode 16, the p-n junction between the p-type semiconductor layer 10 and the n-type semiconductor layer 12 emits light having a peak wavelength of about 685 nm. The graph of Figure 2 shows the wavelength spectrum of the emitted light and the relationship between wavelength and the transmittivity of the optical filter 20 in the case of this first embodiment. Light intensity has been normalized to a peak-wavelength intensity of 1.0. Figure 2 shows that the transmittivity of the optical filter 20 increases at peak wavelength λc - 720 nm. A rise in the temperature of this light-emitting device is accompanied by a narrowing of the energy gap of the semiconductor, thereby shifting the emission spectrum toward the longer-wavelength side at a rate of about 0.24 nm/°C, as has been described. However, as with the optical filter 20 used in this first embodiment the rise in temperature is accompanied by an increase in the amount of light transmitted by the filter, it becomes possible to compensate for the decrease in the amount of light from the p-n junction caused by the rise in temperature.

If it is assumed that there is an approximate parity between the amount by which the light from the p-n junction decreases with the rise in temperature and the amount by which the light is increased by changing the transmittivity of the optical filter (which can be done by regulating the thickness and refractive index of the optical filter), then it becomes possible to maintain the amount of light transmitted by the optical filter 20 at a substantially constant level, even when there is a shift toward the longer-wavelength side. The solid line in Figure 3 indicates the light intensity thus maintained at a constant level.

In the first embodiment the optical filter 20 was formed over the entire surface of the light-emitting device. However, the optical filter 20 may instead be formed so that it covers only part of the light-emitting device.

Figure 4 shows the cross-section of an arrangement in which the optical filter 20 covers only part of the light-emitting device, and Figure 5 is a plan view of the light-emitting device shown in Figure 4. As can be seen in Figure 5, the optical filter 20, constituted of alternating layers of titanium oxide thin film and silicon oxide thin film, is formed only at the region 22a portion of the light-emitting region 22 and is not formed at the other region 22b. With this arrangement, a portion of the light emitted from the p-n junction (the light impinging on region 22a) passes through the optical filter 20, and the remaining portion of the light (the light impinging on region 22b) is externally emitted without passing through optical filter 20. As has been described with reference to the first embodiment, the intensity of the light transmitted by the optical filter 20 can be increased as the temperature rises by adjusting the thickness and refractive index of the film to satisfy $dT/d\lambda c \geq 0$. With the rise in temperature, there is a decrease in the intensity of the light that does not pass through the optical filter 20. Therefore, by adjusting the ratio of the area of the regions 22b to that of region 22a, the overall intensity of the emitted light, that is, the sum of the light that passes through the optical filter 20 and the light that does not pass through the filter, can be maintained at a constant level, unaffected by the rise in temperature.

Thus, as in accordance with this second embodiment the intensity of the emitted light is controlled by the area occupied by the optical filter, the characteristics of the light-emitting device can be more readily changed compared to the configuration in which the filter covers the entire surface of the device.

The above first and second embodiments describe an arrangement in which an optical filter 20 having a single optical transmission characteristic either covers all or part of the device surface. In an arrangement according to a third embodiment, multiple optical filters having different transmission characteristics are disposed at different positions on the device.

As an example of such a device, Figure 6 shows a cross-section of two types of optical filters with different transmission characteristics provided in different positions on the light-emitting device. With reference to Figure 6, arranged at region 22a is an optical filter consisting of multiple alternating layers of titanium oxide thin film and silicon oxide thin film. Arranged at region 22b is an optical filter consisting of a number of an alternating thin film titanium oxide layer and a silicon oxide thin film layer that differs from the number of such layers comprising the optical filter of region 22a. As regions 22a and 22b have a different number of thin film layers of titanium oxide and silicon oxide, the two regions have different optical transmission characteristics. With this arrangement, part of the light from the p-n junction impinges on region 22a and the remaining portion of the light passes through region 22b, so the light from the p-n junction is thereby passed through the respective optical filters having different transmission characteristics. Hence, if the overall increase in light intensity provided by the changes in transmittivity is substantially the same as the decrease in light intensity caused by the rise in temperature of the p-n junction, in overall terms it is possible to maintain the emission intensity at a constant level regardless of the temperature.

Region 22b can be fabricated by, for example, using electron beam evapolation to form a multiplicity of layers over the whole surface of the light-emitting device, followed by photolithography to produce a mask that sets the position of the regions 22a and 22b, and then etching away the required number of region 22b layers.

Thus, the arrangement according to the third embodiment comprises using optical filter means having two kinds of transmission characteristics to control the intensity of the emitted light, providing a configuration that enables the characteristics of the light-emitting device to be even more readily changed compared to the arrangements of the first and second embodiments.

While in the above description the n-type semiconductor is GaAsP that contains tellurium, it will be understood that the invention is not limited thereto. Instead, GaAsP containing other elements such as tin, selenium, sulfur, germanium, and silicon may also be used. Similarly, the p-type semiconductor may be GaAsP that contains elements such as magnesium, manganese or cadmium.

Also, while in the above description of the invention the p-type semiconductor is formed by the diffusion of an impurity, the p-type semiconductor may instead be formed by ion implantation or the like. Moreover, the light-emitting device of this invention is not limited to GaAsP semiconductor but may be constituted of AlGaAs, InGaAsP or any other semiconductor that will form a light-emitting device in which an increase in temperature is accompanied by a decrease in emission intensity and a change in emission wavelength.

Similarly, while the invention has been described with reference to a p-n homojunction, a heterojunction will provide the same effect. With respect also to the optical filter, the invention is not limited to the combination of films of titanium oxide and silicon oxide described above, but may also use other combinations of films having different refractive indexes, such as films of titanium oxide and aluminum oxide. The same effect can also be achieved with a combination of films containing a substance having a wavelength-dependent absorption index.

The light intensity only needs to be maintained at a constant level in terms of the overall wavelength distribution of the emitted light. Thus, even though there may be a decrease in transmittivity as a result of a shift by part of the emission spectrum toward the longer wavelength side, this will not matter so long as this shift is accompanied by an overall increase in the amount of transmitted light. Therefore, with respect to the transmission dependency of the thin film, even if there is minimal number of thin film layers in the regions where the shift to the longer wavelength takes place, by satisfying the condition $dT/d\lambda c \geq 0$ with respect to the center wavelength $\lambda c$ of the emitted light spectrum, in overall terms it becomes possible to maintain the intensity of the emitted light at a constant level. By having optical filter layers as a multiple-layer arrangement of alternating thin film layers that have different indexes of refraction makes it readily possible to provide the optical filter with transmission characteristics that are substantially constant with respect to the emission wavelength distribution.

The invention has been described in detail with particular reference to certain preferred embodiments thereof, but it will be understood that variations and modifications can be effected within the spirit and scope of the invention.

**Claims**

1. A light-emitting device, comprising:
   a) a light-emitting section providing a p-n junction which emits light; and
   b) optical filter means having a plurality of thin film layers disposed relative to the light-emitting section for providing increased light transmittivity in. response to a decrease in emitted light caused by a rise in temperature of the light-emitting section.

2. The light-emitting device according to claim 1 in which the optical filter means includes thin film layers which have different indexes of refraction.

3. The light-emitting device according to claim 1 in which the optical filter means is formed over a portion of a prescribed area ratio relative to the area of the light-emitting section for receiving and transmitting a portion of the emitted light.

4. The light-emitting device according to claim 2 in which the optical filter means is formed over a portion of a prescribed area ratio relative to the area of the light-emitting section for receiving and transmitting a portion of the emitted light.

5. The light-emitting device according to claim 2 in which the optical filter means includes a multiple of optical filters having different transmission characteristics.

6. A light-emitting device, comprising:
   a) a light-emitting section providing a junction which emits light; and
   b) optical filter means
   disposed relative to the light-emitting section for providing increased light transmittivity in response to a decrease in emitted light caused by a rise in temperature of the light-emitting section.

FIG. 1

FIG. 2

**FIG. 3**

NORMALIZED LIGHT INTENSITY vs TEMPERATURE (°C)

PRIOR ART

**FIG. 4**

FIG. 5

FIG. 6

FIG. 7
(prior art)